# EUROPEAN PATENT APPLICATION

(11) **EP 1 333 495 A2**
(43) Date of publication of application: **06.08.2003**
(21) Application number: 03075051.7
(22) Date of filing: 08.01.2003
(51) Int. Cl.: H01L 23/495, H01L 21/48

(54) **High density wire bondable connector assembly**

(30) Priority: 31.01.2002 US 59404
(71) Applicant: Delphi Technologies, Inc., Troy, MI 48007 (US)
(72) Inventor: Fulk, Mikel R., Tipton, IN 46072 (US); Key, Jason M., Galveston, IN 46932 (US); Bednarz, Jacob A., Kokomo, IN 46902 (US)
(74) Representative: Denton, Michael John

(57) **Abstract**

A wire bondable connector assembly (10) is provided. It includes a lead element (12) having a lead portion (14) and a carrier strip portion (16). A first coining area (20) and a second coining area (22) are formed in the lead element (12). The wire bondable connector assembly further includes a connector housing (18) securing the lead portion (14) of the lead element (12). The connector housing (18) includes a fence element (24) covering the first coining area (20) such that the carrier strip portion (16) may be separated from the lead portion (14) at the second coining area (22), while the lead portion (14) remains secure within the conector housing (18).

## Description

### Technical Field

The present invention relates generally to a wire bondable connector assembly and more particularly a wire bondable connector assembly with improved resiliency.

### Background Of The Invention

Wiring bonding is well known in the electronics industry as a method of inner connecting chips, substrates, and output pins. The small profile of the wire bonds makes them well-suited for applications utilizing high-density connectors. One known form of wire bonding is commonly referred to as ultrasonic wire bonding. Ultrasonic wire bonding, as its name suggests, utilizes ultrasonic vibrational energy to bond the thin wire bonds to the chips, substrates, or connector pads. Although the use of ultrasonic wire bonding has proven highly successful, its application often is not without difficulty.

One such difficulty arises when the leads (such as connector pins) are not adequately secured. When the leads are loosened, there can be subsequent movement during the ultrasonic wire bonding process that may prevent the bonds from adequately forming. Often, complex and costly clamping procedures are required to minimize this movement. These clamping procedures, however, in addition to being costly may not be practical when applied to the small surface are of lead frames commonly utilized in high density connectors. It may be far more practical to address the problem of lead movement by modification of the lead and connector design rather than through modifications in the ultrasonic wire bonding process.

Analyzing present connector designs, it is possible to determine at least one source of lead movement. The lead is often molded into a connector housing using plastic molding. Often several leads are held together by a single carrier strip that remains outside the connector housing during the molding process. This provides an efficient method of locating the leads during molding. In an operation referred to as coining, the leads are scored allowing them to be bent and broken off such that the individual leads may be separated. It is during this process of bending and breaking apart the individual leads that the leads can become traumatized and loosened within their seats. Thus, the traumatization of the leads experienced during post-coining separation of the strips may be responsible for difficulties arising with the ultrasonic wire bonding process.

It would therefore be highly desirable to have a method and apparatus for forming a connector with leads wherein the leads were adequately secured throughout the production process and thereby produce a surface properly suited for ultrasonic wire bonding.

### Summary of the Invention

It is therefore an object of the present invention to provide a wire bondable connector assembly with adequately secured connector leads such that the connector leads provide a consistent and suitable surface for ultrasonic wire bonding.

In accordance with the object of the present invention, a wire bondable connector assembly is provided. The wire bondable connector assembly includes at least one lead element having a lead portion and a carrier strip portion. The at least one lead element includes a first coining area and a second coining area. The wire bondable connector assembly further includes a connector housing securing the lead portion of the lead element. The connector housing includes a fence element covering the first coining area such that the carrier strip portion may be separated from the lead portion at the second coining area while the lead portion remains secure within the connector housing.

Other objects and features of the present invention will become apparent when combined in light of the detailed description of the preferred embodiment with taken in conjunction with the attached drawings and appended claims.

### Brief Description of the Drawings

Figure 1 is a cross-sectional illustration of one embodiment of a wire bondable connector assembly in accordance with the present invention;
Figure 2 is a cross-sectional illustration of the wire bondable connector assembly shown in Figure 1, the assembly shown with a detached carrier strip; and
Figure 3 is an isometric illustration of the wire bondable connector assembly shown in Figure 1.

### Description of the Preferred Embodiment(s)

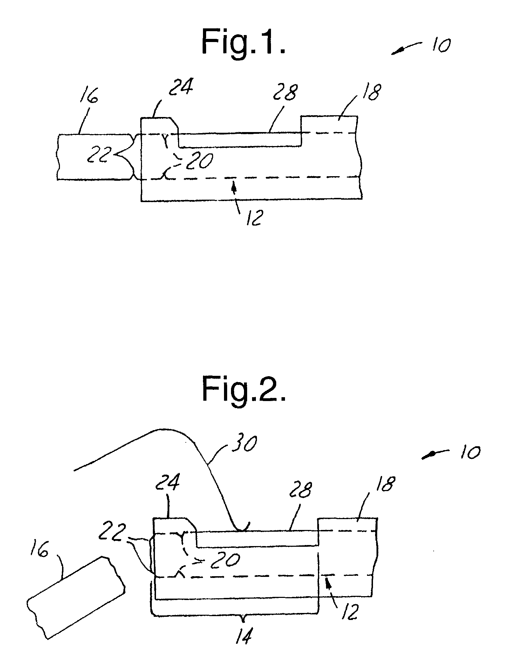

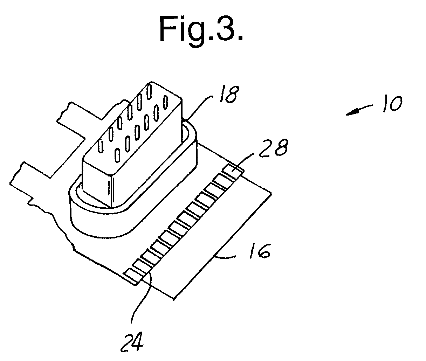

Referring now to Figure 1 which is a cross-sectional illustration of an embodiment of a wire bondable connector assembly 10 in accordance with the present invention. The wire bondable connector assembly 10 includes a lead element 12. A large variety of materials and shapes may be utilized to form the lead element 12. The lead element 12 may take the form of a pin, a pad, a strip, or a host of other configurations. What is common, however, among all of these configurations is that the lead element 12 is commonly formed with a lead portion 14 and a carrier strip portion 16. The use of the carrier strip 16 is a known and common method for securing the wire bondable connector assembly 10 during manufacturing formation (see Figure 3). Once construction of the wire bondable connector assembly 10 has been completed, the carrier strip portion 16 is typically bent off and broken away (see Figure 2).

The present invention further includes connector housing 18. Although the connector housing 18 may be formed in a variety of fashions, in one embodiment the connector housing 18 is molded around the lead element 12 in order to secure the lead portion 14 into the wire bondable connector assembly 10. In the past, when the carrier strip portion 16 is bent and broken away, it may traumatize the lead portion 14 remaining in the connector housing 18 and thereby leave the lead portion 14 loose and unsuitable for ultrasonic wire bonding. The present invention reduces this phenomenon by including a first coining area 20 and second coining area 22 on the lead element 12. Coining is an operation known in the prior art which scores the lead element 12. In the past, coining was utilized primarily to facilitate the bending and breaking away the carrier strip portion 16. The present invention utilizes the second coining area 22 in a similar fashion to the prior art, but further includes the first coining area 20 which is used to reduce the impact of the breaking away of the carrier strip 16 on the lead portion 14.

The present invention reduces this impact by further including a fence element 24 covering the first coining area 20. The use of the fence element 24 to cover the first coining area 20 increases the stability of the lead portion 14 thereby creating a wire bondable connector assembly 10 with increased resistance to damage during the separation of the carrier strips 16. In one embodiment, the fence element 24 is extended to cover portion of the second coining are 22 to provide further support of the lead portion 14 during separation of the carrier strip portion 16 (see Figure 2). The resultant wire bondable connector assembly 10 is subsequently left with a lead surface 28 suitable for attaching a wire bond 30 using ultrasonic wire bonding.

Although a variety of dimensional variations may be utilized for the present invention, in one embodiment, the distance between the first coining area 20 and the second coining area 22 is at least 0.8 mm. This distance has been found to provide the stability to the lead portion 14 for a variety of common materials used to form the lead element 12 and the connector housing 18. It should be understood, however, that a wide variety of different materials may be used to form the lead element 12 and the connector housing 18 that may alter the preferable distance between the first coining area 20 and the second coining area 22. Although the lead element 12 and the connector housing 18 may be formed from a variety of materials, in one embodiment the lead element 12 is formed from metal while the connector housing is formed using PBT plastic.

One particular embodiment of the invention to be shown and described, numerous creations of alternative embodiments will occur to those skilled in the art. Accordingly it is intended that the invention be limited to only in terms of the appended claims.

## Claims

1. A wire bondable connector assembly 10 comprising:
at least one lead element 12 including a lead portion 14 and a carrier strip portion 16;
a first coining area 20 formed in said lead portion 14 of said lead element 12;
a second coining area 22 formed in said lead element 12 and positioned between said lead portion 14 and said carrier strip portion 16; and
a connector housing 18 formed around said lead portion 14, said connector housing 18 including said fence element 24 covering the said first coining area 20 such that said carrier strip portion 16 can be separated from said lead portion 14 without affecting the stability of said lead portion 14.

2. A wire bondable connector assembly 10 as described in claim 1 wherein said fence element 24extends to cover a portion of said second coining area 22.

3. A wire bondable connector assembly 10 as described in claim 1 wherein said first coining area 20 and said second coining area 24 are separated by at least 0.8 mm.

4. A wire bondable connector assembly 10 as described in claim 1 wherein said connector housing 18 is plastic.

5. A wire bondable connector assembly 10 as described in claim 1 wherein said fence element 24 is formed integrally with said connector housing 18.

6. A wire bondable connector assembly 10 as described in claim 1 wherein said connector housing 18 is formed around said lead portion 14 using injection molding.

7. A wire bondable connector assembly 10 as described in claim 1 wherein said lead portion 14 further include a lead surface 28 suitable for ultrasonic wire bonding.

8. A wire bondable connector assembly 10 as described in claim 1 for use in a high density wire bond connector.

9. A method of securing wire bondable leads in a connector housing comprising:
coining a lead element 12 in a first coining area 20 and a second coining area 22;
forming a connector housing 18 over a lead portion of said lead element 12;
forming a fence portion 24 over said first coining area 20; and
separating a carrier strip portion 16 from said lead portion 14 in the location of said second coining area 22.

10. The method described in claim 9 further comprising the step of forming said fence portion to cover at least a portion of said second coining area.

11. The method described in claim 9 further comprising:
wire bonding a wire bond 30 to a lead surface 28 of the lead element 12 using ultrasonic wire bonding.

12. The method as described in claim 9 wherein said first coining area 20 and said second coining area 22 are at least 0.8 mm apart.

13. The method as described in claim 9 wherein said lead element 12 is a pin.

14. The method as described in claim 9 wherein said lead element 12 is a pad.

15. The method as described in claim 9 wherein said connector housing 18 is molded using PBT plastic.
